# EUROPEAN PATENT APPLICATION

(11) **EP 4 574 746 A1**
(43) Date of publication of application: **25.06.2025**
(21) Application number: 23218558.7
(22) Date of filing: 20.12.2023
(51) Int. Cl.: B81B 3/00

(54) **MEMS DEVICE**

(71) Applicant: Murata Manufacturing Co., Ltd., Nagaokakyo-shi, Kyoto 617-8555 (JP)
(72) Inventor: LIUKKU, Matti, 00320 Helsinki (FI); PARTANEN, Mikko, 01710 Vantaa (FI); BLOMQVIST, Anssi, 00980 Helsinki (FI)
(74) Representative: Boco IP Oy Ab

(57) **Abstract**

The disclosure relates to a microelectromechanical device comprising a device layer, wherein a movable structure, one or more first and second translation springs and a first and a second electrostatic in-plane transducers are in the device layer. The in-plane force transducers and the translation springs may move the movable structure out-of-plane. An advantage of the arrangement of the disclosure is that out-of-plane movement to the large tilt angles is achieved by in-plane transducers which require lower voltage in comparison to two-layer tilting transducer structures.

## Description

### FIELD OF THE DISCLOSURE

The present disclosure relates to a MEMS device with a movable part.

### BACKGROUND OF THE DISCLOSURE

Microelectromechanical (MEMS) devices, such as MEMS mirrors or accelerometers, often comprise at least one movable part which needs to be rotated out-of-plane. For example, MEMS mirrors may usually benefit from large out-of-plane tilting displacement to allow wide range of angles or positions. One way to implement out-of-plane rotation is described in a document US2021396993A1. A MEMS device of US2021396993A1 comprises a first layer that includes a stator comb actuator and a second layer that includes a rotor comb actuator, and tilting is achieved by engaging a plurality of teeth of the stator comb actuator with a plurality of teeth of the rotor comb actuator. However, an actuator of US2021396993A1 with the stator and the rotor parts at the different layers would require large electrostatic force to achieve large tilting angles and may restrict tilting angles range. Thus, another solution which does not require excessively large electrostatic forces and allows out-of-plane rotation to the large tilting angles is needed.

### BRIEF DESCRIPTION OF THE DISCLOSURE

An object of the present disclosure is to provide a MEMS device so as to solve the above problem.

The object of the disclosure is achieved by an arrangement which is characterized by what is stated in the independent claim. Some embodiments of the disclosure are disclosed in the dependent claims.

The disclosure is based on the idea of using an in-plane force transducer and translation springs to move a movable structure out-of-plane. An advantage of the arrangement of the disclosure is that out-of-plane movement to the large tilt angles is achieved with lower voltage in comparison to two-layer tilting structures.

### BRIEF DESCRIPTION OF THE DRAWINGS

In the following the disclosure will be described in greater detail by means of preferred embodiments with reference to the accompanying drawings, in which:
Figure 1 illustrates a general operation principle of a disclosed MEMS device;
Figure 2a illustrates a top view of the MEMS device of this disclosure;
Figure 2b illustrates a close view of a transducer structure of an electrostatic in-plane transducer;
Figures 2c and 2d illustrate a cross section of the MEMS device of this disclosure with different options of how z-coordinates of two connection points are in relation to z-coordinate of a first rotation axis in a vertical direction;
Figure 3a illustrates a first embodiment of the MEMS device comprising four transducer structures and two translation springs on each side from the first rotation axis;
Figure 3b illustrates an expanded view of one of the transducer structures with additional static combs on a static comb finger and additional moving combs on a moving comb finger;
Figure 4a illustrates a second embodiment of the MEMS device comprising four transducer structures and four translation springs on each side from the first rotation axis;
Figure 4b illustrates how the movable structure may rotate around the first translation axis;
Figure 5a illustrates an example of a 2-axis MEMS device with suspension structures, wherein the movable structure may comprise a frame and a reflector inside the frame, and wherein the movable structure is rotated around the first rotation axis.
Figure 5b illustrates an example of a 2-axis MEMS device with suspension structures, wherein the reflector is rotated around a second rotation axis.
Figure 6a illustrates an expanded view of a third embodiment of the MEMS device with a torsion suspension structure.
Figure 6b illustrates the third embodiment in more detail, wherein z-coordinate of a torsion spring is different from z-coordinates of the translation springs and the first rotation axis in the vertical direction.
Figure 7 illustrates an exemplary fabrication process of the MEMS device of this disclosure.

### DETAILED DESCRIPTION OF THE DISCLOSURE

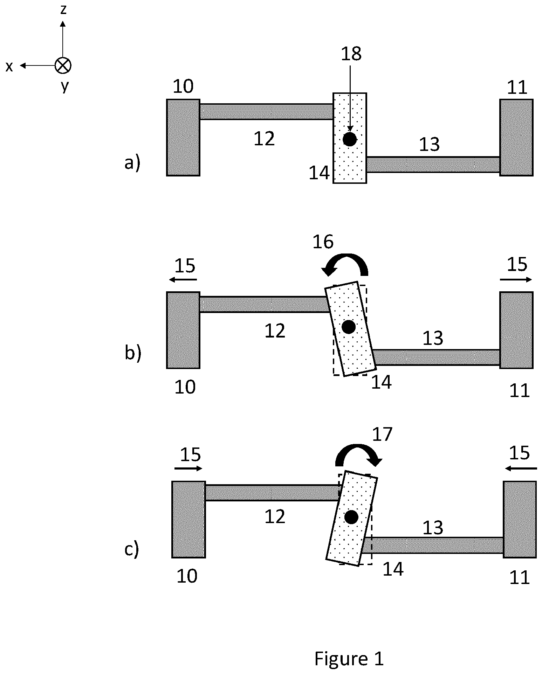

The invention of this disclosure is based on the idea schematically illustrated in Figure 1. Each of two transducer structures 10-11 of an in-plane transducer may be connected to two springs 12-13 with a tilting structure 14 in-between as shown in Figure 1 a). The springs may transfer the force from the transducer to the tilting structure if the transducer is an actuator transducer, which may be configured to produce movement. Alternatively, the springs may transfer force from the tilting structure to the transducer if transducer is a sense transducer, which may be configured to detect movement. Thus, out of plane movement of the tilting structure may be achieved by in-plane transducer.

As illustrated in Figure 1 b) and c), if b) the force 15 is applied away from the tilting structure 14, the springs 12-13 may pull the tiling structure 14 and rotate it to a first direction 16, which is the counter clockwise direction. If c) the force 15 is applied towards the tilting structure 14, the springs 12-13 may push the tiling structure 14 and rotate it to a second direction 17in which is a clockwise direction. In both cases, the tilting structure may be rotated around a rotation axis, which may be parallel to the y-direction and passing through a rotation point 18.

A microelectromechanical device comprising a device layer, wherein a vertical direction is perpendicular to the device layer; a movable structure in the device layer, wherein a first rotation axis extends through the movable structure and lies in the device layer, an electrostatic in-plane force transducer, which comprises one or more first transducer structure on a first side from the first rotation axis, and one or more second transducer structure on a second side from the first rotation axis; and one or more first translation spring, which extends from the movable structure to the electrostatic in-plane force transducer on the first side from the first rotation axis, and one or more second translation spring which extends from the movable structure to the electrostatic in-plane force transducer on the second side from the first rotation axis, and wherein the first and the second translation springs are in the device layer; and one or more first translation spring is connected to the movable structure at one or more first connection point, and one or more second spring is connected to the movable structure at one or more second connection point; and wherein z-coordinates of one or more first connection point and one or more second connection point in the vertical direction are different from z-coordinate of the first rotation axis in the vertical direction.

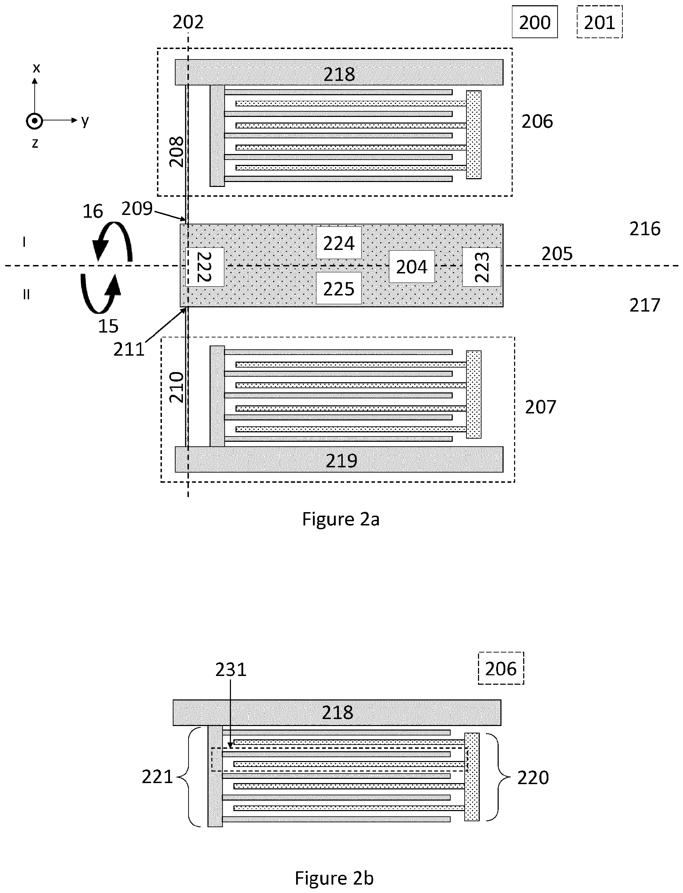

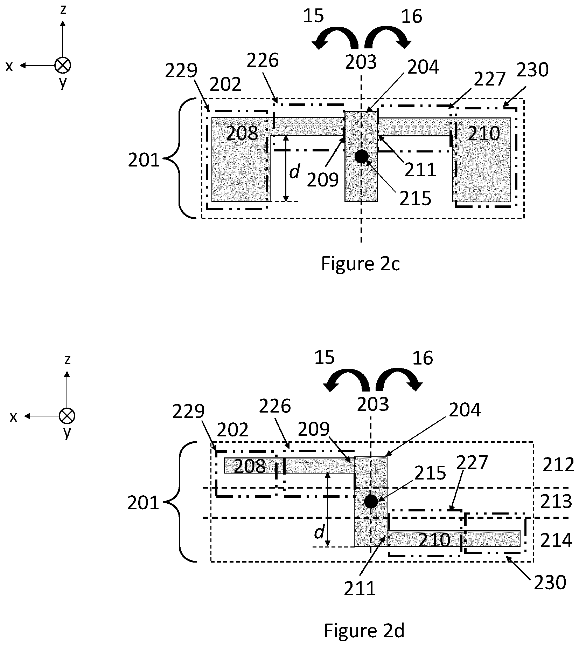

A microelectromechanical (MEMS) device 200 is illustrated in Figure 2a. The MEMS device 200 of the Figure 2a may function according to the idea schematically illustrated in Figure 1 and described above. The MEMS device comprises a device layer 201. The device layer 201 comprises all structures shown in Figure 2a. The xz-cross section 202 of the device layer 201 is illustrated in Figures 2c and 2d. The term "device layer" signifies a combination of layers and structures fabricated in these layers. Specifically, the device layer may comprise multiple layers and structures. The device layer may be parallel to a xy-plane comprised of an x-axis and a y-axis. Directions which extend parallel to x-axis and y-axis may correspondingly be called an x-direction and a y-direction. Some structures may be rigidly fixed in the device layer. Those fixed structures may be generalized as "a static part of the MEMS device". Some structures may be configured to move in the device layer. Some structures may be configured to move out of the device layer. The thickness of the device layer may be 50 um - 100 um.

A vertical direction 203 of the MEMS device may be defined as a direction perpendicular to the device layer as illustrated in Figure 2c. The vertical direction may extend parallel to z-axis and be called a z-direction.

Words such as "plane", "vertical" and "direction" etc. do not in this disclosure refer to the orientation of the device with regard to the direction of earth's gravitational field either when the device is manufactured or when it is in use. Instead, the word "layer" defines a plane and "vertical" defines a direction which is perpendicular to that plane.

A movable structure 204 is in the device layer. The movable structure may correspond to the tilting structure 14 of Figure 1. A first rotation axis 205 passes through the movable structure and lies in the device layer 201. Figure 2c illustrates a xz-cross section 202 with a rotation point 215 through which the first rotation axis 205 may pass. The first rotation axis may pass through the rotation point 215 and through centre of mass (not illustrated) of the movable structure in xz-plane. The movable structure may comprise four sides: a first side 222 and a second side 223 through which the first rotation axis passes through, and a third side 224 and a fourth side 225 which may be non-intersecting with the first rotation axis 205. Alternatively, the third side 224 and the fourth side 225 may be to the side from the first rotation axis 205. Alternatively, the third side 224 and the fourth side 225 may be parallel to the first rotation axis 205. The first side 222 may be opposite to the second side 223, and the third side 224 may be opposite to the fourth side 225.

The movable structure 204 may have any shape. The movable structure may have rectangular shape. Four edges of the rectangular movable structure may correspond to four sides of the movable structure. Alternatively, the movable structure may have circular shape. The circular movable structure may comprise four quadrants, and a circumference of a curve of each quadrant may correspond to four sides of the movable structure. In addition, the movable structure may have an irregular shape. For example, the movable structure of circular or rectangular main shape may further comprise areas of any shape protruding out from the main shape in the device layer.

An electrostatic in-plane force transducer comprises one or more first transducer structures 206 on a first side 216 of the first rotation axis 205. The electrostatic in-plane force transducer further comprises one or more second transducer structures 207 on a second side 217 of the first rotation axis 205. An exemplary first transducer structure 206 is illustrated in Figure 2b.

The electrostatic in-plane force transducer may comprise one or more outer support beams. A first outer support beam 218 may be at the first side 216 from the first rotation axis 205. A second outer support beam 219 may be at the second side 217 from the first rotation axis 205. Furthermore, the electrostatic in-plane force transducer may comprise one or more inner support beams (not illustrated in Figures). A first inner support beam may be at the first side 216 from the first rotation axis 205 and between one or more first transducer structures 206 and the movable structure 204. Alternatively, the first inner support beam may be between one or more first transducer structures 206 and one of two tilting bar (described later in this disclosure). The first inner support beam may be attached to one or more first transducer structures 206 and provide support to them. A second inner support beam may be at the second side 217 from the first rotation axis 205 and between one or more second transducer structures 207 and the movable structure 204. Alternatively, the second inner support beam may be between one or more second transducer structures 207 and one of two tilting bar (described later in this disclosure). The second inner support beam may be attached to one or more second transducer structures 206 and provide support to them.

One or more transducer structures may be comb structures as illustrated in Figure 2b. Each comb structure may comprise a plurality of static comb fingers on a static support structure 220 alternating with a plurality of moving comb fingers on a moving support structure 221. The static comb fingers may be interdigitated with the moving comb fingers.

The moving support structure with the moving comb fingers 221 may be attached to the adjacent outer support beam 218. In other words, multiple moving support structure with the moving comb fingers of the multiple transducer structures may be attached to the same outer support beams. The outer support beams may be movably fixed to the static part of the MEMS device. The outer support beam may be movably fixed by means of, for example, suspension structures (not illustrated in Figure 2a-2b). The static support structure with the static comb fingers 220 may be rigidly fixed to the static part of the MEMS device.

In the transducer structure 206 illustrated in Figure 2b, the static and moving comb fingers may form comb finger pairs. Each comb finger pair may comprise one static comb finger and one moving comb finger. One comb finger pair 231 is illustrated. When a voltage is applied between the static comb fingers and the moving comb fingers, the moving comb fingers in each comb finger pair may be moving towards the static comb fingers, thus initiating the in-plane movement in the device layer. The invention may be realized by other comb fingers configurations or types of capacitive transducers.

The electrostatic in-plane force transducer may be an electrostatic in-plane force actuator. Alternatively, the electrostatic in-plane force transducer may be an electrostatic in-plane sense transducer.

The comb structure may act as the electrostatic in-plane force actuator when the voltage is applied between each pair of moving and static comb fingers. When voltage is applied, the moving comb finger may move towards static comb finger along x-direction initiating in-plane movement of the whole electrostatic in-plane force transducer. Specifically, the pair of adjacent moving and static comb fingers may be called a "comb fingers pair". The moving comb finger of each fingers pair may be configured to move towards the static comb finger in the same comb fingers pair.

The comb structure may act as the electrostatic in-plane sense transducer when the moving comb finger is moved towards the static comb finger under influence of external force or when the movement is produced by the actuator. The changing distance between the static and moving comb fingers may be used to define voltage change and correspondingly sense the movement.

In any part of this application, the electrostatic in-plane force transducer may be called "the transducer".

A term "translation spring" may refer to a structure which is configured to transfer force between the movable structure and the electrostatic in-plane force transducer. The translation spring may be a continuing uninterrupted strip. In other words, the translation spring may be a solid beam and have no breaks such as hinges or joints. The translation spring may have width in the y-direction significantly smaller than its length in the x-direction. The thickness of the translation spring in the z-direction may be, at least in some regions, smaller than the thickness of the device layer in the z-direction. The thickness of the translation spring may be less than 20 um in the z-direction. The thickness of the translation spring may be greater than 2 um in the z-direction.

One or more first translation spring 208 may be connected to the electrostatic in-plane force transducer on the first side 216 of from the first rotation axis 205. One or more second translation spring 210 may be connected to the electrostatic in-plane force transducer on the second side 217 of from the first rotation axis 205. In particular, one or more first translation spring 208 may be connected to the first outer support beam 218. One or more second translation spring 210 may be connected to the second outer support beam 219.

One or more first translation spring 208 of Figures 2c - 2d is connected to the movable structure at one or more first connection point 209, and one or more second translation spring 210 is connected to the movable structure at one or more second connection point 211. The z-coordinates of one or more first connection points and one or more second connection points in the vertical direction are different from z-coordinate of the first rotation axis in the vertical direction and corresponding rotation point 215.

The microelectromechanical device, wherein z-coordinate of one or more first connection point in the vertical direction is greater than z-coordinate of the first rotation axis in the vertical direction, and z-coordinate of one or more first connection point in the vertical direction is same as z-coordinate of one or more second connection point in the vertical direction.

Specifically, as Figure 2c illustrates, the z-coordinates of one or more first connection point 209 and one or more second connection point 211 in the vertical direction may be larger than of the first rotation axis 205 in the vertical direction and the corresponding rotation point 215. The z-coordinates of one or more first connection point 209 and one or more second connection point 211 may be equal. In other words, the first and second connection points 209 and 211 may lie on the same side of the first rotation axis 205 in the vertical direction.

In Figure 2c, the z-coordinate of the first rotation axis 205 and the corresponding rotation point 215 is illustrated in the centre of the movable structure in the vertical direction. In practice, the z-coordinate of the first rotation axis 205 and the corresponding rotation point 215 may be non-aligned with the centre of the movable structure in the vertical direction. Instead, the z-coordinate of the first rotation axis 205 and the corresponding rotation point 215 may be aligned with the z-coordinate of the centre of a torsion spring of a torsion suspension structure, which is described later in this application.

The microelectromechanical device, wherein z-coordinate of one or more first connection point in the vertical direction is smaller than z-coordinate of the first rotation axis in the vertical direction, and z-coordinate of one or more first connection point in the vertical direction is same as z-coordinate of one or more second connection point in the vertical direction.

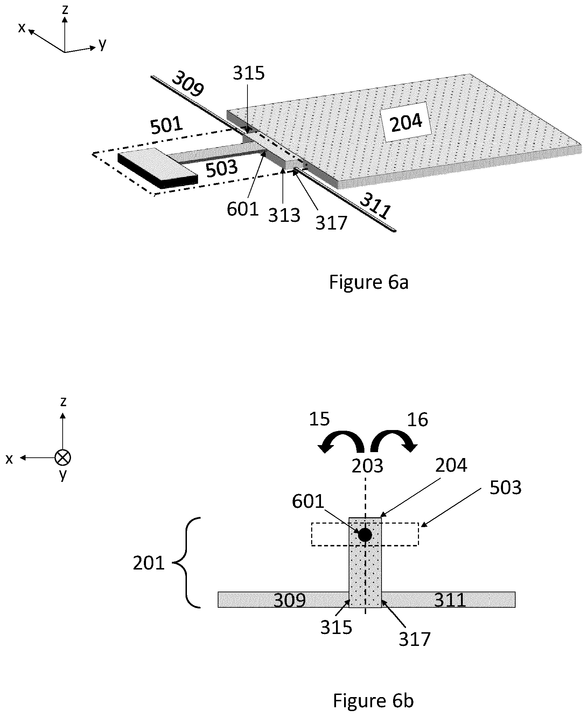

The z-coordinates of one or more first connection point 209 and one or more second connection point 211 in the vertical direction may be smaller than of the first rotation axis 205 in the vertical direction and the corresponding rotation point 215. Corresponding arrangement is illustrated in Figure 6b and is discussed in more detail later in this application.

The microelectromechanical device, wherein z-coordinate of one or more first connection point in the vertical direction is greater than z-coordinate of the first rotation axis in the vertical direction, and z-coordinate of the first rotation axis in the vertical direction is greater than z-coordinate of one or more second connection point in the vertical direction.

As illustrated in Figure 2d, the first and second connection points 209 and 211 may lie on the opposite sides of the rotation axis 205 and the corresponding rotation point 215 in the vertical direction. The z-coordinates of one or more first connection point 209 in the vertical direction may be larger than the z-coordinate of the first rotation axis 205 and corresponding rotation point 215 in the vertical direction, and z-coordinates of one or more second connection point 211 in the vertical direction may be smaller than the z-coordinate of the first rotation axis 205 and corresponding rotation point 215 in the vertical direction. In other words, z-coordinates of one or more first connection point 209, and one or more second connection point 211 may be different and, respectively, larger and smaller than z-coordinate of the first rotation axis 205 and corresponding rotation point 215 in the vertical direction.

In the example of Figure 2d, the z-coordinate of the first rotation axis 205 and corresponding rotation point 215 in the vertical direction may be defined by differential forces produced by the first translation spring 208 and the second translation spring 210, which push or pull the movable structure in the opposite direction along the x-direction. The z-coordinate of the first rotation axis 205 may, but does not have to, lie in the middle of the movable structure 402, as Figure 204 illustrates..

### Operating principle of the MEMS device

Out-of-plane movement of the movable structure is initiated by the electrostatic in-plane transducer. As was described above, the electrostatic in-plane transducer may be a) an electrostatic actuator transducer or b) an electrostatic sense transducer.

### a) Electrostatic in-plane actuator transducer functionality

The electrostatic in-plane transducer of Figure 2a (or of any other embodiment of this disclosure) may be an electrostatic in-plane actuator transducer. When an electric field is applied between the fingers of the electrostatic in-plane actuator transducer, the moving comb fingers move with respect to the static comb fingers in the device layer either upward or downward along x-direction. In-plane displacement of the moving comb fingers of the electrostatic actuator transducer generates the movement of the first and the second translation springs connected to the electrostatic in-plane actuator transducer. The first and the second translation springs may move along x-direction, pulling or pushing the movable structure. Since the first and the second translation springs are connected to the movable structure at the first and the second connection points which have different z-coordinate than z-coordinate of the first rotation axis and the corresponding rotation point, the movable structure may rotate around the first rotation axis in a clockwise direction or a counter clockwise direction. In other words, pulling or pushing by the first and the second translation sprigs may generate oscillation movement of the movable structure, where the clockwise and counter clockwise directions alternate.

In the example of Figure 2c, the first transducer structure 206 and the first translation spring 208 may move in the negative x-direction, and the second transducer structure 207 and the second translation spring 210 may also move in the negative x-direction. Thus, the first translation spring 208 may pull the movable structure 204 and the second translation spring 210 may push the movable structure 204, thus generating counter clockwise movement around the first rotation axis 205. Alternatively, the first transducer structure 206 and the first translation spring 208 may move in the x-direction, and the second transducer structure 207 and the second translation spring 210 may also in the x-direction. Thus, the first translation spring 208 may push the movable structure 204 and the second translation spring 210 may pull the movable structure 204, thus generating clockwise movement around the first rotation axis 205.

In the example of Figure 2d, which corresponds to the example described with reference to Figure 1 above, the first transducer structure 206 and the first translation spring 208 may move in the negative x-direction, and the second transducer structure 207 and the second translation spring 210 may move in the x-direction. Thus, the first translation spring 208 may pull the movable structure 204 and the second translation spring 210 may pull the movable structure 204, thus generating counter clockwise movement around the first rotation axis 205. Alternatively, the first transducer structure 206 and the first translation spring 208 may move in the x-direction, and the second transducer structure 207 and the second translation spring 210 may move in the negative x-direction. Thus, the first translation spring 208 may push the movable structure 204 and the second translation spring 210 may push the movable structure 204, thus generating clockwise movement around the first rotation axis 205.

In other words, the electrostatic in-plane actuator transducer(s) may generate in-plane movement and transfer the movement to the first and second translation springs. The first and second translation springs may further transfer the movement to the movable structure and move it out-of-plane. Thus, the in-plane electrostatic actuator transducer may initiate out-of-plane oscillation movement of the movable structure.

### b) Electrostatic in-plane sense transducer functionality

The electrostatic in-plane transducer of Figure 2a (or of any other embodiment of this disclosure) may be an electrostatic in-plane sense transducer. The electrostatic in-plane sense transducer may be configured to sense the position of the movable structure when it is moved out-of-plane. The movement of the movable structure out-of-plane may generate movement in the first and the second translation springs, which may then be transferred to the electrostatic in-plane sense transducer by moving the moving comb fingers. The sensing of the displacement may be based on change of the capacitance between the static and moving comb fingers. In other words, when the moving comb fingers move with relation to the static comb fingers, the capacitance changes with respect to the amount of displacement. The out-of-plane displacement of the movable structure may then be defined.

Figures 2c and 2d illustrate a xz-cross section 202 of the MEMS device 200. The structures in the device layer 201 in the xz-cross section 202 may have different thickness in the vertical direction. For example, as Figure 2c illustrates, the thickness of the first 208 and the second 210 translation springs may be smaller in inside regions 226 and 227 than in outside regions 229 and 230. The inside regions 226 and 227 may be attached to the movable structure 204, The thickness of the outside regions 229 and 230 may be same as the thickness of the movable structure 204 in the vertical direction. Alternatively, as Figure 2d illustrates, the thickness of the first 208 and the second 210 translation springs in the inside regions 226 and 227 may be same as the thickness in the outside regions 229 and 230. The thickness of the inside regions 226 and 227 and outside regions 229 and 230 may be smaller than the thickness of the movable structure 204 in the vertical direction.

The device layer 201 in the xz-cross section 202 may be recessed to comprise different thicknesses. In particular, the first 208 and the second 210 translation springs may be recessed so that their thickness is smaller in the inside regions 226 and 227 than in the rest of the device layer 201. In other words, the first 208 and the second 210 translation springs may be recessed to a recess depth din the z-direction as illustrated in Figure 1c. Alternatively, the first 208 and the second 210 translation springs may be recessed to the recess depth *d* in the negative z-direction (not illustrated). Alternatively, as Figure 2d illustrates, the first translation spring 208 may be recessed to the recess depth *d* in the z-direction, and the second translation spring 210 may be recessed to the recess depth din the negative z-direction. Alternatively, each of the translation springs may be recessed in both the z-direction and in the negative z-direction (not illustrated). The device layer may be recessed with a recess etching. In the recess etching, some structures of the device layer may be recessed to a certain thickness. In other words, only some depth of the device layer may be etched away in order to achieve the recessed depth *d* in certain areas of the device layer.

Alternatively, the device layer may be formed of stacked layers, such as a first layer 212, a second layer 213 and a third layer 214 illustrated in Figure 2d. The second layer may be between the first and the third layer. The first translation spring 208 with the first connection point 209 and a first part of the movable structure 204 may be formed in the first layer 212.

A second part of the movable structure may be formed in the second layer 213. The second translation spring 210 with the second connection point 211 and a third part of the movable structure 204 may be formed in the third layer 214. The rotation point 215 may be in the second layer 213.

### Embodiments

Some embodiments of this disclosure are described below in detail.

The MEMS device, wherein the microelectromechanical device comprises two tilting bars, wherein a first tilting bar is at a first side of the movable structure and a second tilting bar is at a second side of the movable structure, and wherein the first side is opposite to the second side, and wherein the first and the second tilting bars extend along the first rotation axis, and wherein one or more first connection points and one or more second connection points are at the tilting bars.

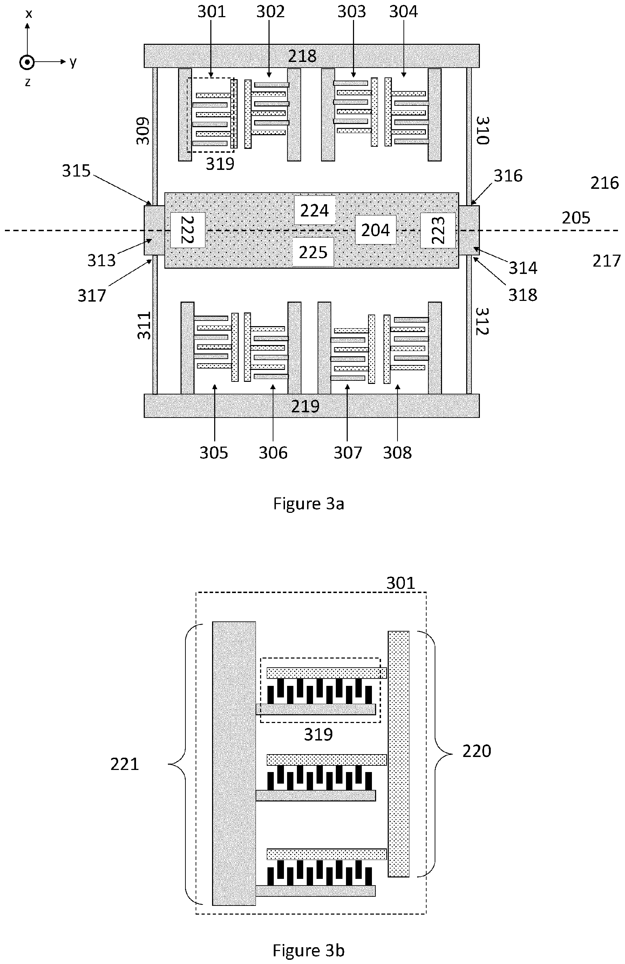

The MEMS device may comprise two tilting bars 313-314 as illustrated in Figure 3a. The tilting bars 313-314 may be at the opposite sides of the movable structure and may be rigidly fixed to the movable structure 204. The tilting bars 313-314 may be part of the movable structure 204. A first tilting bar 313 may be at the first side 222 of the movable structure 204 and a second tilting bar 314 may be at the second side 223 of the movable structure 204. The tilting bars may extend along the first rotation axis 205. The first rotation axis 205 may pass through the centre of the tilting bars in the x-direction and in the z-direction. A first side of each tilting bar may be at the first side 216 from the first rotation axis 205. A second side of each tilting bar may be at the second side 217 from the first rotation axis 205.

The width of the first tilting bar 313 and the second tilting bar 314 may be smaller than the width of the rest of the movable structure 204 in x-direction. The purpose of this geometry may be to increase the length of the first and the second translation springs and bring them closer to the first rotation axis 205. Since the first translation springs and the second translation springs act as levers, this may result in increasing the torque and increasing the tilting angle of the rotated movable structure. Figures 3a-5 illustrate MEMS device with the tilting bars 313-314. However, the same example may be implemented without the tilting bars.

### Embodiment 1

The microelectromechanical device, wherein the electrostatic in-plane force actuator comprises four first transducer structures on a first side from the first rotation axis, and four second transducer structures on a second side from the first rotation axis, and wherein at least two first translation springs are on the first side from the first rotation axis, and at least two second translation springs are on the second side from the first rotation axis, and wherein the four first transducer structures are between at least two first translation springs, and wherein the four second transducer structures are between at least two second translation springs.

As illustrated in Figure 3a, the electrostatic in-plane force transducer may comprise four first transducer structures on a first side from the first rotation axis 205. The electrostatic in-plane force transducer may comprise four second transducer structures on a second side from the first rotation axis 205. In other words, the electrostatic in-plane force transducer may comprise first transducer structures such as 301, 302, 303 and 304, and second transducer structures 305, 306, 307 and 308 in Figure 3a.

The MEMS device with four first and four second transducer structures may comprise two first translation springs 309 and 310 on the first side 216 from the first rotation axis 205, and two second translation springs 311 and 312 on the second side 217 from the first rotation axis 205. Two first connection points may be at the movable structure on the first side 216 from a rotation point 215. Two second connection points may be at the movable structure on the second side 217 from a rotation point 215. Specifically, one first connection point 315 may be at the first side of the first tilting bar 313 and one first connection point 209 may be at the first side of the second tilting bar 314. One second connection point 317 may be at the second side of the first tilting bar 313 and one second connection point 318 may be at the second side of the second tilting bar 314. Thus, each translation spring may be attached to one connection point at each side of the two tiling bars.

Each of the two first translation springs 309 and 310 on the first side from the first rotation axis may extend between the electrostatic in-plane force transducer and one first connection points at the movable structure 204. Each of the two second translation springs on the second side from the rotation axis may extend between the electrostatic in-plane force transducer and one second connection points at the movable structure. Specifically, each of the two first translation springs 309 and 310 on the first side from the rotation axis may extend between the first outer support beam 218 and the adjacent tilting bar 313 or 314. Each of the two second translation springs 311 and 312 on the second side from the rotation axis may extend between the second outer support beam 219 and the adjacent tilting bar 313 or 314.

In the example of Figure 3a, the four first transducer structures 301-304 may be between the two first translation springs 309 and 310. The four second transducer structures 305-308 may be between the two second translation springs 311 and 312. The four first transducer structures 301-304 may be along the third side 224 of the movable structure 204, and the four second transducer structures 305-308 may be along the fourth side 225 of the movable structure 204.

The MEMS device of Figure 3a may function in the following way. The moving comb fingers may move with respect to the static comb fingers in device plane either upward or downward along x-direction. Specifically, two first transducer structures, such as 301 and 304, and two second transducer structures, such as 306 and 307 may be configured to move in x-direction. Two first transducer structures, such as 302 and 303, and two second transducer structures, such as 305 and 308 may be configured to move in the negative x-direction. This configuration may initiate movement of the translation springs in a direction defined by the combination of actuated transducer structures.

If z-coordinate of one or more first connection point in the vertical direction is larger than z-coordinates of the first rotation axis in the vertical direction, and z-coordinate of the first rotation axis in the vertical direction is larger than z-coordinates of one or more second connection point and as illustrated in Figure 2d, the MEMS device may move as follows:
a) The first transducer structures 302 and 303 may be actuated to move in the negative x-direction in the device layer 202 when the voltage is applied between the static comb fingers and the moving comb fingers. Thus, the first translation springs 309-310 may move in the negative x-direction in the device layer 202. The second transducer structures 306 and 307 may be actuated to move in the device layer 202 in x-direction when the voltage is applied between the static comb fingers and the moving comb fingers. Thus, the second translation springs 311-312 may move in the positive x-direction in the device layer 202. The first and the second translation springs 309-312 may push the movable structure and rotate it in the clockwise direction.
b) The first transducer structures 301 and 304 may be actuated to move in the device layer 202 in the positive x-direction when the voltage is applied between the static comb fingers and the moving comb fingers. Thus, the first translation springs 309-310 may move in the device layer 202 in the positive x-direction. The second transducer structures 305 and 308 may be actuated to move in the device layer 202 in the negative x-direction when the voltage is applied between the static comb fingers and the moving comb fingers. Thus, the second translation springs 311-312 may move in the device layer 202 in the negative x-direction. The first and the second translation springs 309-312 may pull the movable structure and rotate it in the counter clockwise direction.

Figure 3b illustrates interdigitated static and moving comb fingers in more detail. Each static and moving combs in the comb fingers pair may respectively comprise a plurality of additional static combs interdigitated with a plurality of additional moving combs. The additional static combs may interdigitate with the additional moving combs as in marked region 319. Such arrangement may increase electrostatic force between comb fingers, when a displacement larger than comb fingers pair without additional moving combs can provide is required. In addition, the arrangement increases the distance the moving comb fingers travel towards the static comb fingers thus increasing the displacement of the first and the second translation springs in the device layer and rotation of the movable structure out of the device layer. Similar additional static combs and additional moving combs may be implemented in the transducer structure illustrated in Figure 2b.

### Embodiment 2

The microelectromechanical device, wherein the electrostatic in-plane force actuator comprises a first, a second, a third and a fourth first transducer structures on a first side from the first rotation axis, and a first, a second, a third and a fourth second transducer structures on a second side from the first rotation axis, and wherein at least a first, a second, a third and a fourth first translation springs are on the first side from the first rotation axis, and at least a first, a second, a third and a fourth second translation springs are on the second side from the first rotation axis, and wherein the first and the second first transducer structures are between the first and the second first translation springs, and the third and the fourth first transducer structures are between the third and the fourth first translation springs, and wherein the first and the second transducer structures are between the first and the second translation springs, and the third and the fourth second transducer structures are between the third and the fourth second translation springs.

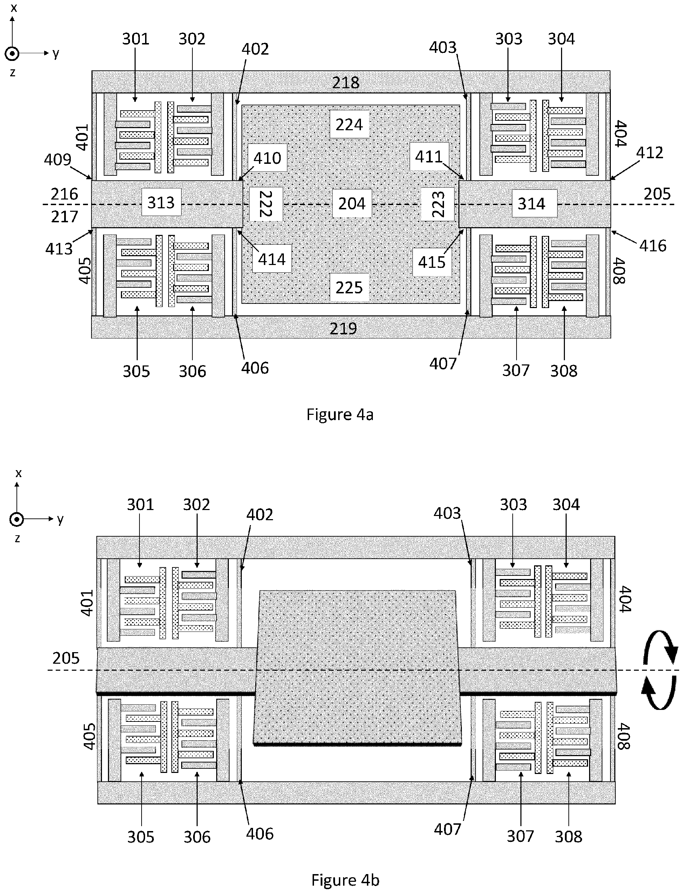

Figure 4a illustrates another embodiment of MEMS device of this disclosure. The electrostatic in-plane force actuator may comprise four first transducer structures on a first side from the first rotation axis. The electrostatic in-plane force actuator may comprise four second transducer structures on a second side from the first rotation axis.

The MEMS device with four first transducer structures 301-304 and four second transducer structures 305-308 may comprise four first translation springs 401-404 on the first side 216 from the first rotation axis 205, and four second translation springs 405-408 on the second side 217 from the first rotation axis 205. Four first connection points 409-412 may be at movable structure at the first side 216 from the first rotation axis 205, and four second connection points 413-416 may be at the movable structure at the second side 217 from the first rotation axis 205. Specifically, two first connection points 409-410 may be at the first side of the first tilting bar 313 and two first connection points 411-412 may be at the first side of the second tilting bar 314. Two second connection points 413-414 may be at the second side of the first tilting bar 313 and two second connection points 415-416 may be at the second side of the second tilting bar 314. Thus, two translation springs may be attached to two connection points at each side of the two tiling bars.

Each of the four first translation springs 409-412 on the first side from the first rotation axis may extend between electrostatic in-plane force transducer and one adjacent first connection points at the movable structure. Each of the four second translation springs 413-416 on the second side from the first rotation axis may extend between the electrostatic in-plane force transducer and one adjacent second connection point at the movable structure. Specifically, each of the four first translation springs 409-412 on the first side from the rotation axis may extend between the first outer support beam 218 and the adjacent tilting bar. Each of the four second translation springs 413-416 on the second side from the rotation axis may extend the second outer support beam 219 and the adjacent tilting bar.

In the example of Figure 4a, two first transducer structures may be between two first translation springs (e.g. 301-302 between 401-402), and another two first transducer structures may be between another two first translation springs (e.g. 303-304 between 403-404). Two second transducer structures may be between two second translation springs (e.g. 305-306 between 405-406), and another two second transducer structures may be between another two second translation springs (e.g. 307-308 between 407-408). The two first transducer structures 301-302 may be along the first tilting bar 313 at the first side 222 of the movable structure, and other two first transducer structures 303-304 may be along the second tilting bar 314 at the second side 223 of the movable structure. The two second transducer structures 305-306 may be along the first tilting bar 313 at the first side 222 of the movable structure, and other two second transducer structures 307-308 may be along the second tilting bar 314 at the second side 223 of the movable structure.

The MEMS device of Figure 4a may function in the following way. The moving comb fingers may move with respect to the static comb fingers in device plane either in or in the negative x-direction. Specifically, two first transducer structures, such as 301 and 304, and two second transducer structures, such as 306 and 307 may be configured to move in x-direction. Two first transducer structures, such as 302 and 303, and two second transducer structures, such as 305 and 308 may be configured to move in the negative x-direction. This configuration may initiate movement of the translation springs in a direction defined by the combination of actuated transducer structures.

If z-coordinate of one or more first connection point in the vertical direction is larger than z-coordinates of the first rotation axis in the vertical direction, and z-coordinate of the first rotation axis in the vertical direction is larger than z-coordinates of one or more second connection point and as illustrated in Figure 2d, the MEMS device may move as follows:
a) The first transducer structures 302 and 303 may be actuated to move in the negative x-direction in the device layer 202 when the voltage is applied between the static comb fingers and the moving comb fingers. Thus, the first translation springs 402 and 403 may move in the negative x-direction in the device layer. The second transducer structures 306 and 307 may be actuated to move in the device layer in the positive x-direction when the voltage is applied between the static comb fingers and the moving comb fingers. Thus, the second translation springs 406 and 407 may move in the positive x-direction in the device layer. The first and the second translation springs may push the movable structure and rotate it in the clockwise direction.
b) The first transducer structures 301 and 304 may be actuated to move in the device layer in the positive x-direction when the voltage is applied between the static comb fingers and the moving comb fingers. Thus, the first translation springs 401 and 404 may move in the device layer in the positive x-direction. The second transducer structures 305 and 308 may be actuated to move in the device layer in the negative x-direction when the voltage is applied between the static comb fingers and the moving comb fingers. Thus, the second translation springs 405 and 408 may move in the device layer in the negative x-direction. The first and the second translation springs may pull the movable structure and rotate it in the counter clockwise direction.

Specifically, the eight connection points may be arranged so that some of the first and some of the second connection points lie on the opposite sides of the rotation axis in the z-direction:
(1) The z-coordinates of four first connection points 409-412 in the vertical direction may be larger than the z-coordinate of the first rotation axis 205 in the vertical direction and corresponding rotation point 215, and z-coordinates of four second connection points 413-416 in the vertical direction may be smaller than the z-coordinate of the first rotation axis 205 in the vertical direction and corresponding rotation point 215.
(2) The z-coordinates of two first connection points 409 and 411 in the vertical direction may be larger than the z-coordinate of the first rotation axis 205 in the vertical direction and corresponding rotation point 215, and z-coordinates of two second connection points 414 and 416 in the vertical direction may be larger than the z-coordinate of the first rotation axis 205 in the vertical direction and corresponding rotation point 215. The z-coordinates of two first connection points 410 and 412 in the vertical direction may be smaller than the z-coordinate of the first rotation axis 205 in the vertical direction and corresponding rotation point 215, and z-coordinates of two second connection points 413 and 415 in the vertical direction may be smaller than the z-coordinate of the first rotation axis 205 in the vertical direction and corresponding rotation point 215. This arrangement may comprise a torsion suspension structure attached to the movable structure as described later in this application.
(3) The z-coordinates of two first connection points 409 and 412 in the vertical direction may be larger than the z-coordinate of the first rotation axis 205 in the vertical direction and corresponding rotation point 215, and z-coordinates of two second connection points 413 and 416 in the vertical direction may be larger than the z-coordinate of the first rotation axis 205 in the vertical direction and corresponding rotation point 215. The z-coordinates of two first connection points 410 and 411 in the vertical direction may be smaller than the z-coordinate of the first rotation axis 205 in the vertical direction and corresponding rotation point 215, and z-coordinates of two second connection points 414 and 415 in the vertical direction may be smaller than the z-coordinate of the first rotation axis 205 in the vertical direction and corresponding rotation point 215. This arrangement may comprise a torsion suspension structure attached to the movable structure as described later in this application.

Figure 4b illustrates an example of how the movable structure with the tilting bars may be rotated around the first rotation axis 205.

### Suspension structures

The microelectromechanical device comprises two torsion suspension structures, and wherein each torsion suspension structure comprises a torsion spring, and wherein at least two torsion springs extend along the first rotation axis in the device layer and are connected to opposite sides of the movable structure at two torsion points, and wherein z-coordinate of the first rotation axis corresponds to z-coordinate of each of the two torsion points, and wherein the z-coordinate of each of the two torsion points is different from z-coordinate of each of one or more first and second connection points in the vertical direction.

### Torsion suspension structures

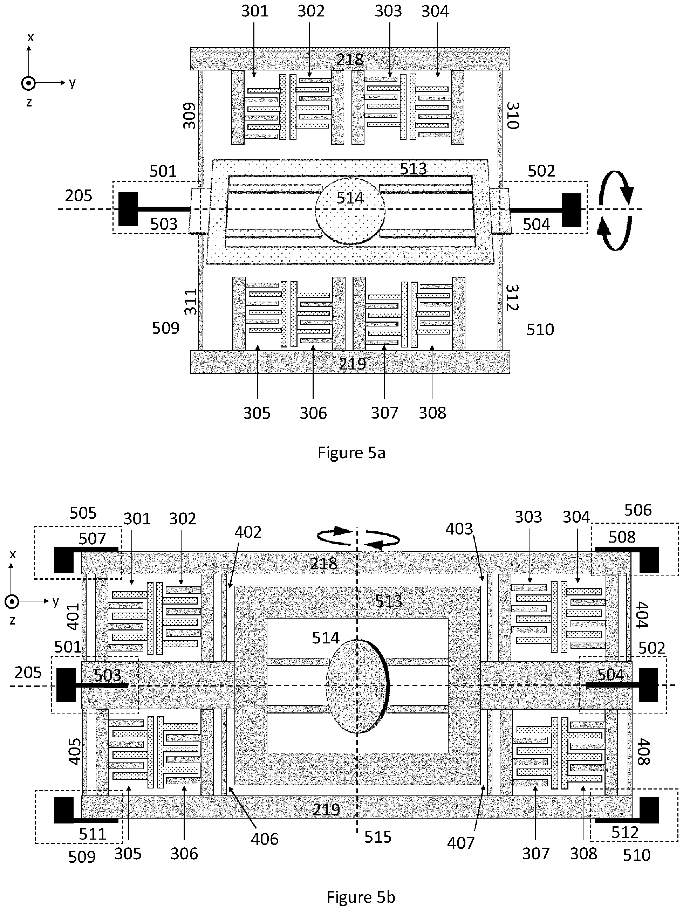

Any embodiment of this disclosure may comprise at least two torsion suspension structures 501-502, as illustrated in Figures 5a - 5b. Each torsion suspension structure may comprise a torsion spring 503-504. One function of the torsion suspension structures may be to support the movable structure 204 to reduce its movement in the x- or z-direction. In addition, the torsion suspension structures may reduce the drive force needed for rotating the movable structure.

The torsion suspension structures 501-502 with the torsion springs 503-504 may fix the movable structure to the static part of the MEMS device. The torsion springs 503 and 504 may extend along the first rotation axis 205. The torsion springs 503 and 504 may be attached to the opposite side of the movable structure 204. Specifically, the torsion springs 503 and 504 may be attached to the outermost side of the movable structure at the first side and the second side correspondingly. The torsion springs 503 and 504 may be directly attached to the first tilting bar and the second tilting bar correspondingly as in Figure 5a.

Alternatively, in any embodiment of this disclosure, the torsion springs 503-504 may be integrated into the movable structure as Figure 5b demonstrates. The purpose of such modification in to reduce the size of the MEMS mirror structure.

The width of the torsion springs may be larger in the x-direction than the thickness in the z-direction. The width of the torsion spring may define if the torsion spring can withstand the net force in the x-direction. In addition, the sufficient width in the x-direction may provide stiffness to the torsion spring and prevent its movement in the x-direction.

### Embodiment 3

Figures 6a and 6b illustrate another embodiment of the MEMS device with the torsion suspension structure. As Figure 6a illustrates, the z-coordinate of the torsion spring 503 and a corresponding torsion point 601 may be different from the z-coordinate of one or more first connection point 315 (not visible in Figure 6a, visible in Figure 6b) and one or more second connection point 317 in the vertical direction. In this arrangement, the wherein z-coordinate of the first rotation axis corresponds to z-coordinate of each of the torsion points (for example, the torsion point 601 in Figure 6b). The torsion point 601 is drawn in the centre of the torsion spring 503 in the vertical direction and in the x-direction in Figure 6b for illustrative purposes. In practice, it can be non-aligned with the centre depending on the actual arrangement of the translation spring 503. Specifically, as shown in Figure 6b, the z-coordinates of one or more first connection point 315 and one or more second connection point 317 may be the same and smaller than the z-coordinate of the torsion spring 503 and a corresponding torsion point 601 in the vertical direction. Alternatively, the z-coordinates of one or more first connection point 315 and one or more second connection point 317 may be the same and greater than the z-coordinate of the torsion spring 503 and a corresponding torsion point 601 in the vertical direction (not illustrated).

The torsion springs may be recessed in a similar manner as the translation springs described above with reference to Figures 2c - 2d. Specifically, the arrangement illustrated in Figures 5a, 5b, 6a and 6b may be achieved by recessing the torsion springs and the translation sprigs in different directions along z-axis. Specifically, referring to example of Figures 6a - 6b, the torsion spring 503 may be recessed in the positive z-direction, and the translation sprigs 309 and 311 may be recessed in the negative z-direction. In other words, the torsion spring 503 may be recessed from bottom of the device layer 201, and the translation sprigs 309 and 311 may be recessed from top of the device layer 201.

The MEMS device of Figure 5a, where the z-coordinate of the torsion spring 503 and a corresponding torsion point 601 is larger than the z-coordinates of one or more first connection point 315 and one or more second connection point 317 in the vertical direction, may function in the following way:
a) The first transducer structures 302 and 303 may be actuated to move in the negative x-direction in the device layer 202 when the voltage is applied between the static comb fingers and the moving comb fingers. Thus, the first translation springs 309-310 may move in the negative x-direction in the device layer 202. The second transducer structures 306 and 307 may be actuated to move in the device layer 202 in the negative x-direction when the voltage is applied between the static comb fingers and the moving comb fingers. Thus, the second translation springs 311-312 may move in the negative x-direction in the device layer 202. The first translation springs 309-310 may push, and the second translation springs 311-312 may pull the movable structure and rotate it in the counter clockwise direction.
b) The first transducer structures 301 and 304 may be actuated to move in the device layer 202 in the positive x-direction when the voltage is applied between the static comb fingers and the moving comb fingers. Thus, the first translation springs 309-310 may move in the device layer 202 in the positive x-direction. The second transducer structures 305 and 308 may be actuated to move in the device layer 202 in the positive x-direction when the voltage is applied between the static comb fingers and the moving comb fingers. Thus, the second translation springs 311-312 may move in the device layer 202 in the positive x-direction. The first translation springs 309-31 0 may pull, and the second translation springs 311-312 may push the movable structure and rotate it in the clockwise direction.

The MEMS device of Figure 5b, where the z-coordinate of the torsion spring 503 and a corresponding torsion point 601 is larger than the z-coordinate of the first rotation axis and the corresponding rotation point 215 in the vertical direction, and where the z-coordinate of the first rotation axis and the corresponding rotation point 215 is larger than the z-coordinates of one or more first connection point 315 and one or more second connection point 317 in the vertical direction, may function in the following way:
a) The first transducer structures 302 and 303 may be actuated to move in the negative x-direction in the device layer 202 when the voltage is applied between the static comb fingers and the moving comb fingers. Thus, the first translation springs 402 and 403 may move in the negative x-direction in the device layer. The second transducer structures 306 and 307 may be actuated to move in the device layer in the negative x-direction when the voltage is applied between the static comb fingers and the moving comb fingers. Thus, the second translation springs 406 and 407 may move in the negative x-direction in the device layer. The first translation springs may push, and the second translation springs may pull the movable structure and rotate it in the counter clockwise direction.
b) The first transducer structures 301 and 304 may be actuated to move in the device layer in the positive x-direction when the voltage is applied between the static comb fingers and the moving comb fingers. Thus, the first translation springs 401 and 404 may move in the device layer in the positive x-direction. The second transducer structures 305 and 308 may be actuated to move in the device layer in the positive x-direction when the voltage is applied between the static comb fingers and the moving comb fingers. Thus, the second translation springs 405 and 408 may move in the device layer in the positive x-direction. The first translation springs may pull, and the second translation springs may push the movable structure and rotate it in the clockwise direction.

### In-plane suspension structure

Any embodiment of this disclosure may comprise at least two in-plane suspension structures, as illustrated in Figure 5b. Each in-plane suspension structure may comprise an in-plane spring. One function of the in-plane suspension structures may be to fix some parts of the MEMS device to reduce their movement in the z- or y-direction and allow their movement along x-direction.

The in-plane suspension structures 505-506 with the in-plane springs 507-508 may fix the in-plane electrostatic transducer to the static part of the MEMS device at the first side 216 from the first rotation axis 205. Specifically, the in-plane suspension structures 505-506 with the in-plane springs 507-508 may be attached to the opposite sides of the first outer support beam 218. The in-plane suspension structures 509-510 with the in-plane springs 511-512 may fix the in-plane electrostatic transducer to the static part of the MEMS device at the second side 217 from the first rotation axis 205. Specifically, the in-plane suspension structures 509-510 with the in-plane springs 511-512 may be attached to the opposite sides of the second outer support beam 219.

### Method of fabrication the MEMS device

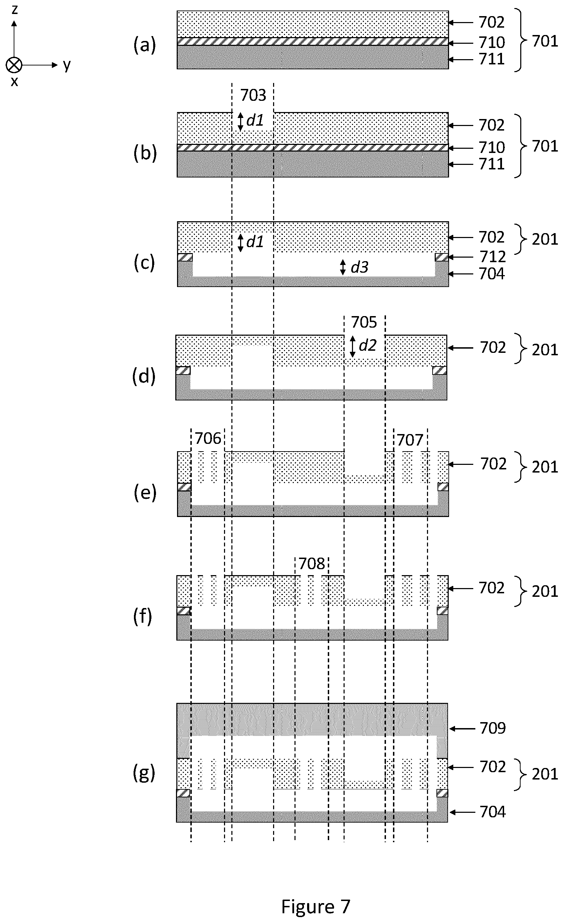

The microelectromechanical device of this disclosure may be fabricated with a method illustrated in Figure 7:
(a) - (b) A top layer 702 of a first wafer 701 may be recessed in a first region 703 to a recess depth d1 in the z-direction.
(c) The first wafer 701 may be flipped in the z-direction, and the top layer 702 may be attached to a second wafer 704 with layer 712 on top. Layers 711 and 710 may be removed. The second wafer 704 may comprise a cavity of d3 depth, which allows rotation of the structures recessed in the top layer 702. The top layer 702 may form a device layer, which corresponds to the device layer 201 described in this disclosure.
(d) The top layer 702 may be recessed in a second region 705 to a recess depth d2 in the z-direction.
(e) The top layer 702 may be etched through in a third region 706 and a fourth region 707 to form structured corresponding to the first and the second transducer structures of this disclosure.
(f) Optionally, the top layer 702 may be recessed through in a fifth region 708 to form structured corresponding to a frame and a reflector in the movable structure (described later in this application).
(g) A cap 709 may be attached to the device layer 201 to enclose the top layer 702 between the cup 709 and the second wafer 704. In this arrangement, the structures in the fifth region 708 may have space to rotate without hitting the walls of the surrounding structures.

### MEMS mirror

The microelectromechanical device according to any preceding claim, wherein the device is a microelectromechanical mirror, and the movable structure comprises a reflector.

The movable structure of this disclosure may comprise a frame 513. It may also comprise a reflector 514. Examples of structures with the frame and the reflector are illustrated in Figures 5a - 5b.

The frame may comprise a second rotation axis 515 which may be perpendicular to the first rotation axis 205. The frame may be a mechanical structure surrounding the reflector. The frame may have a rectangular shape. Other shapes are also possible. A centre of the frame may be defined as a point of its diagonal's intersection. The area surrounded by the edges of the frame may be referred to as inside of the frame. The area outside the edges of the frame may be referred to as the outside of the frame. A width of the frame in the xy-plane may be greater than its thickness in the z-direction.

The reflector is suspended inside the frame along the device layer. The reflector may be movable in relation to the frame. The reflector may comprise a reflective coating deposited onto one of its surfaces. The reflective coating may be one or more metal thin film layers, such as aluminium, silver, gold or copper films. Alternatively, the reflective coating may comprise a stack of one or more dielectric films with different refractive indexes, where the films are arranged so that the stack reflects light. A thickness of the reflective coating may be 100 - 1000 nm depending on the wavelength of the laser used with the MEMS device. For example, the thickness of the reflective coating may be 500 nm. An outermost border of the reflector may be referred to as an edge of the reflector.

The reflector may have rounded shape such as circle or oval. Alternatively, the reflector may have square shape. The reflector may be in the centre of the frame. In other words, the centre of the frame may align with the centre of the reflector in the device layer and z-direction.

The reflector inside the frame may be independently actuated and rotated around the second rotation axis. At least four piezoelectric actuators may be inside the frame. Each piezoelectric actuator may comprise a piezoelectric layer, such as aluminium nitride, deposited on one actuation spring to facilitate actuation movement. Each piezoelectric actuator is configured to bend out of the frame plane. Each piezoelectric actuator extends from the frame towards the reflector. In other words, each piezoelectric actuator may connect one point at the inside of the frame with one point at the edge of the reflector.

The piezoelectric actuators may be arranged in the following manner. A first and a second piezoelectric actuators may be aligned with each other, and a third and a fourth piezoelectric actuators may be aligned with each, and piezoelectric actuators may be parallel to one of the rotation axes. Further, the piezoelectric actuators may be parallel to the first rotation axis, and the piezoelectric actuators may be equidistant from the first rotation axis and perpendicular to the second rotations axis.

## Claims

1. A microelectromechanical device comprising:
• a device layer, wherein a vertical direction is perpendicular to a surface of a device layer,
• a movable structure in the device layer, wherein a first rotation axis extends through the movable structure and lies in the device layer,
• an electrostatic in-plane force transducer, which comprises one or more first transducer structure on a first side from the first rotation axis, and one or more second transducer structure on a second side from the first rotation axis,
• and one or more first translation spring, which extends from the movable structure to the electrostatic in-plane force transducer on the first side from the first rotation axis, and one or more second translation spring which extends from the movable structure to the electrostatic in-plane force transducer on the second side from the first rotation axis, and wherein the first and the second translation springs are in the device layer,
• and one or more first translation spring is connected to the movable structure at one or more first connection point, and one or more second spring is connected to the movable structure at one or more second connection point,
• and wherein z-coordinates of one or more first connection point and one or more second connection point in the vertical direction are different from z-coordinate of the first rotation axis in the vertical direction.

2. The microelectromechanical device according to claim 1, wherein the electrostatic in-plane force actuator comprises four first transducer structures on a first side from the first rotation axis, and four second transducer structures on a second side from the first rotation axis, and wherein at least two first translation springs are on the first side from the first rotation axis, and at least two second translation springs are on the second side from the first rotation axis, and wherein the four first transducer structures are between at least two first translation springs, and wherein the four second transducer structures are between at least two second translation springs.

3. The microelectromechanical device according to claim 1, wherein the electrostatic in-plane force actuator comprises a first, a second, a third and a fourth first transducer structures on a first side from the first rotation axis, and a first, a second, a third and a fourth second transducer structures on a second side from the first rotation axis, and wherein at least a first, a second, a third and a fourth first translation springs are on the first side from the first rotation axis, and at least a first, a second, a third and a fourth second translation springs are on the second side from the first rotation axis, and wherein the first and the second first transducer structures are between the first and the second first translation springs, and the third and the fourth first transducer structures are between the third and the fourth first translation springs, and wherein the first and the second transducer structures are between the first and the second translation springs, and the third and the fourth second transducer structures are between the third and the fourth second translation springs.

4. The microelectromechanical device according to any of the preceding claims, wherein the microelectromechanical device comprises two tilting bars, wherein a first tilting bar is at a first side of the movable structure and a second tilting bar is at a second side of the movable structure, and wherein the first side is opposite to the second side, and wherein the first and the second tilting bars extend along the first rotation axis, and wherein one or more first connection points and one or more second connection points are at the tilting bars.

5. The microelectromechanical device according to any of the preceding claims, wherein the microelectromechanical device comprises two torsion suspension structures, and wherein each torsion suspension structure comprises a torsion spring, and wherein at least two torsion springs extend along the first rotation axis in the device layer and are connected to opposite sides of the movable structure at two torsion points, and wherein z-coordinate of the first rotation axis corresponds to z-coordinate of each of the torsion point, and wherein to z-coordinate of each of the torsion point is different from z-coordinate of each of one or more first and second connection point in the vertical direction.

6. The microelectromechanical device according to any of claims 1-5, wherein z-coordinate of one or more first connection point in the vertical direction is greater than z-coordinate of the first rotation axis in the vertical direction, and z-coordinate of one or more first connection point in the vertical direction is same as z-coordinate of one or more second connection point in the vertical direction.

7. The microelectromechanical device according to any of claims 1-5, wherein z-coordinate of one or more first connection point in the vertical direction is smaller than z-coordinate of the first rotation axis in the vertical direction, and z-coordinate of one or more first connection point in the vertical direction is same as z-coordinate of one or more second connection point in the vertical direction.

8. The microelectromechanical device according to any of claims 1-4, wherein z-coordinate of one or more first connection point in the vertical direction is greater than z-coordinate of the first rotation axis in the vertical direction, and z-coordinate of the first rotation axis in the vertical direction is greater than z-coordinate of one or more second connection point in the vertical direction.

9. A microelectromechanical device according to any of the preceding claims, wherein the device is a microelectromechanical mirror, and the movable structure comprises a reflector.
